# FASCICULE DE BREVET EUROPEEN

(11) **EP 0 703 616 B1**
(45) Date de publication et mention de la délivrance du brevet: **14.07.1999**
(21) Numéro de dépôt: 95401928.7
(22) Date de dépôt: 22.08.1995
(51) Int. Cl.: H01L 23/544

(54) **Procédé de réalisation d'un repère sur une plaquette notamment semiconductrice incluant une structure enterrée**
Verfahren zur Herstellung eines Markierungszeichens auf einer Halbleiterscheibe mit einer vergrabenen Struktur
Manufacturing process of a marking on a semiconductor wafer comprising a buried structure

(30) Priorité: 26.08.1994 FR 9410326
(43) Date de publication de la demande: 27.03.1996
(73) Titulaire: ALCATEL, 75008 Paris (FR)
(72) Inventeur: Mallecot, Franck, F-92120 Montrouge (FR); Legouezigou, Lionel, F-91530 Le Val St. Germain (FR); Artigue, Claude, F-92340 Bourg La Reine (FR); Poingt, Francis, F-91700 Ste Genevieve des Bois (FR); Leclerc, Denis, F-91430 Igny (FR); Pommereau, Frédéric, F-91220 Bretigny-sur-Orge (FR)
(74) Mandataire: Lamoureux, Bernard

(56) Documents cités:
- EP-A- 0 455 090
- EP-A- 0 541 820
- EP-A- 0 564 191
- US-A- 4 563 765
- US-A- 5 157 003
- PATENT ABSTRACTS OF JAPAN vol. 018 no. 478 (P-1796) ,6 Septembre 1994 & JP-A-06 160656 (NGK INSULATORS LTD) 7 Juin 1994,
- PATENT ABSTRACTS OF JAPAN vol. 010 no. 279 (E-439) ,20 Septembre 1986 & JP-A-61 100928 (MITSUBISHI ELECTRIC CORP) 19 Mai 1986,

## Description

La présente invention concerne notamment la réalisation d'un alignement précis bout à bout de deux guides d'ondes optiques formés indépendamment et dont l'un est enterré dans une plaquette, notamment semiconductrice. On utilise pour cela un repère latéral longitudinal, généralement appelé "repère d'hybridation".

Les guides d'ondes optiques sont en forme de rubans et seront appelés ci-après "rubans optiques". Le problème de leur alignement se pose notamment lorsque l'on veut coupler un guide d'ondes amplificateur à un guide d'ondes optiques. Le repère est généralement constitué par un flanc rectiligne creusé dans la plaquette. Il présente une hauteur souvent différente de celle du ruban optique.

Lorsque deux rubans à aligner sont en surface d'une plaquette (rubans dits "externes"), les positions des canaux latéraux de part et d'autre des rubans et de la vallée à une extrémité latérale définissant le repère sont gravées dans une même couche protectrice. On effectue alors une attaque chimique ou par faisceau de particules pour creuser les canaux latéraux des rubans et très partiellement la vallée du repère. Après protection des canaux latéraux et du ruban, on achève l'attaque de la vallée du repère.

Mais si on tentait de transposer ce procédé à l'alignement d'un ruban enterré, dont la formation nécessite une reprise d'épitaxie, cette dernière serait empêchée par le fait que la protection des canaux latéraux des rubans optiques a altéré la paroi de ces canaux alors que cette paroi doit être de bonne qualité cristallographique pour constituer plus tard une interface de reprise d'épitaxie. Or une restauration de cette surface est impossible dans le cas d'une jonction pour amplification par élément de ruban laser, car les rubans optiques doivent avoir une section carrée et étroite. Cette dernière doit être formée entre des canaux profonds qui ne permettent pas une restauration qui modifierait la forme de leur section.

Pour l'alignement d'un ruban enterré dans une plaquette semiconductrice monocristalline, on a formé jusqu'ici le repère d'alignement selon un plan cristallin. Mais ce mode de formation ne convient pas dans le cas de l'hybridation, dans des Vés silicium, d'amplificateurs semiconducteurs à rubans inclinés par rapport aux faces clivées. Les repères d'alignement doivent en effet être alors inclinés par rapport aux faces clivées.

De manière générale la présente invention a pour but d'obtenir sans contrainte cristallographique un positionnement transversal relatif précis de deux éléments devant être gravés indépendamment tels que les flancs d'un ruban optique à enterrer et un repère d'alignement, notamment pour permettre de réaliser ultérieurement un alignement précis bout à bout de deux rubans optiques dont l'un est enterré.

Dans ce but elle a pour objet un procédé de réalisation d'un repère gravé sur une plaquette, notamment semiconductrice, incluant un flanc enterré, ce repère présentant la forme d'un flanc de gravure et définissant la position transversale d'au moins un autre flanc de gravure formé dans la plaquette et constituant le flanc enterré, ce repère et ce flanc enterré étant respectivement formés à l'intérieur d'une zone de repère et d'une zone à enterrer et étant respectivement constitués par les bords d'un creux de repére et d'un creux à enterrer gravés dans ces zones,
ce procédé comportant les étapes successives suivantes :
a) on dépose, dans la zone de repère, une couche de protection, puis sur celle-ci, une couche de conservation de position, les compositions de ces deux couches étant différentes,
b) on dépose une résine photosensible sur la couche de conservation de position et sur la zone à enterrer,
c) on élimine la résine photosensible par photolithographie dans les zones du creux de repère et du creux à enterrer pour définir les positions futures du repère et du flanc à enterrer,
d) on soumet la plaquette à un milieu d'attaque éliminant la fraction de la couche de conservation de position qui n'est pas protégée par la résine photosensible, ce milieu épargnant cette résine, la couche de protection et le matériau de la plaquette, la position du repère étant alors marquée par un bord de la couche de conservation de position,
e) on soumet la plaquette à un milieu d'attaque creusant son matériau pour former le flanc à enterrer, ce milieu épargnant la résine photosensible, la couche de protection et la couche de conservation de position,
f) on élimine la résine photosensible,
g) on dépose un matériau d'enterrement, notamment épitaxialement un matériau semiconducteur, pour enterrer le flanc à enterrer,
h) on protège le matériau de la plaquette dans la zone à enterrer, et
i) on soumet la plaquette à un milieu d'attaque éliminant la partie de la couche de protection qui n'est pas protégée par la couche de conservation de position, ce milieu épargnant la couche de conservation de position et le matériau de la plaquette protégé, ce milieu creusant le matériau de la plaquette non protégé pour former le creux de repère.

Dans un cas typique deux dits flancs à enterrer sont constitués par les deux bords d'un ruban optique qui doit être enterré, deux dits creux à enterrer étant constitués par deux canaux de part et d'autre de ce ruban.

Il est décrit ci-après, à titre d'exemple et en référence aux figures du dessin annexé, la réalisation d'un repère d'alignement longitudinal ou ("repère d'hybridation") d'un ruban optique, pouvant être un ruban optique habituel ou un ruban laser assurant l'amplification du signal du premier ruban optique.

La figure 1 représente une opération de photolithographie exposant à la fois les emplacements des canaux latéraux de part et d'autre du ruban optique et de la vallée du repère d'alignement.

La figure 2 représente une opération d'attaque sélective à travers une résine photosensible éliminant une couche de conservation de position sur l'emplacement de la vallée du repère.

La figure 3 représente une opération subséquente d'attaque sélective à travers la résine photosensible qui creuse les canaux latéraux du ruban sans attaquer la couche de protection ni la couche de conservation de position.

La figure 4 représente l'attaque de la vallée du repère d'alignement.

Au début de l'opération de définition du repère, on dépose dans la zone 1 (à gauche de la figure) où celui-ci doit être formé, au-dessus d'une plaquette 2, par exemple en phosphure d'indium, dans laquelle est réalisée la couche optique 3, une couche de protection 4 surmontée d'une couche de conservation de position 5 (les natures chimiques de ces deux couches étant différentes, par exemple l'une étant en nitrure de silicium et l'autre en oxyde de silicium). On recouvre l'ensemble de ces couches et du substrat par une couche de résine photosensible 6.

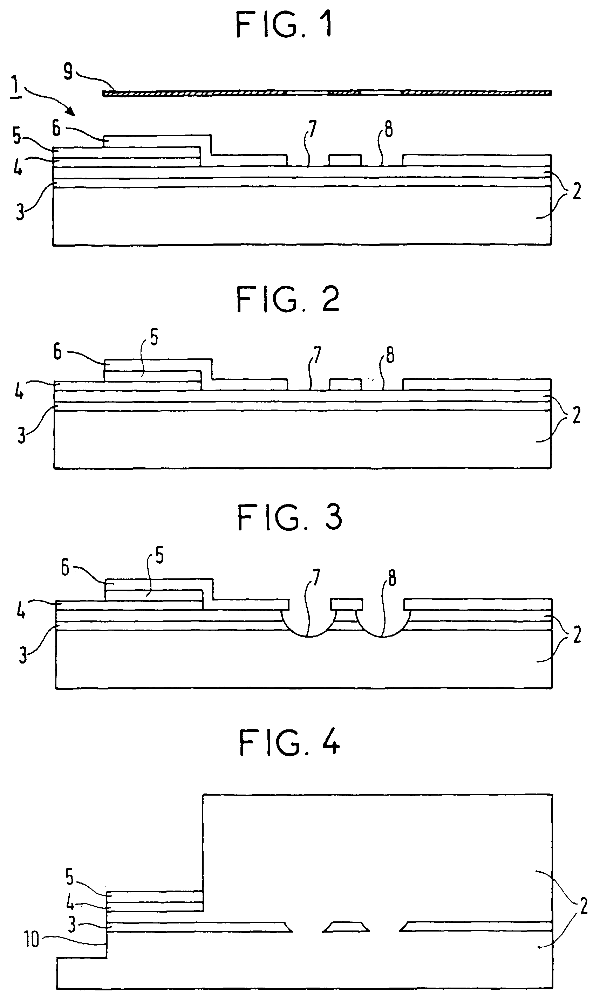

On met alors à nu par photolithographie à l'aide d'un masque 9 à la fois d'une part les emplacements des canaux latéraux 7, 8 du ruban optique et d'autre part celui de la vallée du repère (figure 1).

Une première attaque sélective est réalisée dans les ouvertures de la résine photosensible. Elle élimine la couche de conservation de position 5 sur l'emplacement de la vallée du repère sans attaquer le substrat (figure 2).

Puis une deuxième attaque sélective réalisée dans les mêmes ouvertures creuse les canaux latéraux 7, 8 du ruban sans attaquer la couche de protection 4 ni, latéralement, la couche de conservation de position 5 (figure 3).

Après élimination de la résine on recouvre le ruban optique et les canaux latéraux d'un matériau tel que celui de la plaquette.

Dans une opération ultérieure, on effectue une attaque sélective de la vallée du repère localisée grâce à la couche de conservation de position 5, seules la couche de protection 4 et une certaine épaisseur de la plaquette 2 étant attaquées. On définit ainsi le flanc rectiligne vertical 10 avec une grande précision, pouvant dépasser ± 0,3 micromètre (Figure 4). Ce flanc permet d'assurer un excellent alignement bout à bout du ruban enterré avec un autre.

Les attaques sélectives permettant de former le repère d'alignement et les canaux latéraux du guide d'onde peuvent s'effectuer par gravure sèche (attaque par jets de particules) ou humide (attaque chimique). Les repères d'alignement formés peuvent, en plan, prendre n'importe quelles forme, être inclinés par rapport aux axes cristallographiques du substrat, et être localisés en n'importe quel endroit dans le plan de reprise de l'épitaxie.

## Revendications

1. Procédé de réalisation d'un repère gravé sur une plaquette, notamment semiconductrice, incluant un flanc enterré, ce repère présentant la forme d'un flanc de gravure et définissant la position transversale d'au moins un autre flanc de gravure formé dans la plaquette et constituant le flanc enterré, ce repère et ce flanc enterré étant respectivement formés à l'intérieur d'une zone de repère (1) et d'une zone à enterrer (7) et étant respectivement constitués par les bords d'un creux de repére et d'un creux à enterrer gravés dans ces zones,
ce procédé comportant les étapes successives suivantes :
a) on dépose, dans la zone de repère, une couche de protection (4), puis sur celle-ci, une couche de conservation de position (5), les compositions de ces deux couches étant différentes,
b) on dépose une résine photosensible (6) sur la couche de conservation de position et sur la zone à enterrer,
c) on élimine la résine photosensible par photolithographie dans les zones du creux de repère et du creux à enterrer pour définir les positions futures du repère et du flanc à enterrer,
d) on soumet la plaquette à un milieu d'attaque éliminant la fraction de la couche de conservation de position qui n'est pas protégée par la résine photosensible, ce milieu épargnant cette résine (6), la couche de protection (4) et le matériau de la plaquette, la position du repère étant alors marquée par un bord de la couche de conservation de position,
e) on soumet la plaquette à un milieu d'attaque creusant son matériau pour former le flanc à enterrer, ce milieu épargnant la résine photosensible, la couche de protection et la couche de conservation de position,
f) on élimine la résine photosensible,
g) on dépose un matériau d'enterrement, notamment épitaxialement un matériau semiconducteur, pour enterrer le flanc à enterrer,
h) on protège le matériau de la plaquette dans la zone à enterrer, et
i) on soumet la plaquette à au moins un milieu d'attaque éliminant la partie de la couche de protection qui n'est pas protégée par la couche de conservation de position, ce milieu épargnant la couche de conservation de position et le matériau de la plaquette protégé, ce milieu creusant le matériau de la plaquette non protégé pour former le creux de repère.

2. Procédé selon la revendication 1 dans lequel deux dits flancs à enterrer sont constitués par les deux bords d'un ruban optique qui doit être enterré, deux dits creux à enterrer étant constitués par deux canaux de part et d'autre de ce ruban.

## Patentansprüche

1. Verfahren zur Herstellung einer geätzzen Markierung an einer Platte, insbesondere einer Halbleiterplatte, die eine vergrabene Flanke enthält, wobei diese Markierung die Form einer Ätzflanke aufweist und die transversale Position wenigstens einer anderen Ätzflanke definiert, die in der Platte gebildet ist und die vergrabene Flanke bildet, wobei diese Markierung und diese vergrabene Flanke jeweils innerhalb einer Markierungszone (1) bzw. einer zu vergrabenden Zone (7) gebildet sind und jeweils durch die Ränder einer Markierungsaushöhlung und einer zu vergrabenden Aushöhlung gebildet sind, die in diesen Zonen geätzt sind, wobei das Verfahren die folgenden aufeinanderfolgenden Schritte umfasst:
a) in der Markierungszone wird eine Schutzschicht (4) und dann auf dieser eine Positionserhaltungsschicht (5) abgeschieden, wobei die Zusammensetzungen dieser zwei Schichten verschieden sind,
b) ein lichtempfindliches Harz (6) wird auf der Positionserhaltungsschicht und der zu vergrabenden Zone abgeschieden,
c) das lichtempfindliche Harz wird durch Photolithographie in den Zonen der Markierungsaushöhlung und der zu vergrabenden Aushöhlung beseitigt, um die zukünftigen Positionen der Markierung und der zu vergrabenden Flanke zu definieren,
d) die Platte wird einem Angriffsmedium ausgesetzt, das den Teil der Positionserhaltungsschicht beseitigt, der nicht durch das lichtempfindliche Harz geschützt ist, wobei dieses Medium dieses Harz (6), die Schutzschicht (4) und das Material der Platte verschont, wobei die Position der Markierung dann durch einen Rand der Positionserhaltungsschicht markiert ist,
e) die Platte wird einem Ätzmedium ausgesetzt, das ihr Material aushöhlt, um die zu vergrabende Flanke zu bilden, wobei das Medium das lichtempfindliche Harz, die Schutzschicht und die Positionserhaltungsschicht verschont,
f) das lichtempfindliche Harz wird beseitigt,
g) ein Vergrabematerial, insbesondere epitaxial ein Halbleitermaterial, wird abgeschieden, um die zu vergrabende Flanke zu vergraben,
h) das Material der Platte wird in der zu vergrabenden Zone geschützt und
i) die Platte wird wenigstens einem Angriffsmedium ausgesetzt, das den Teil der Schutzschicht beseitigt, der nicht durch die Positionserhaltungsschicht geschützt ist, wobei dieses Medium die Positionserhaltungsschicht und das geschützte Material der Platte verschont, wobei dieses Medium das nicht geschützte Material der Platte aushöhlt, um die Markierungsaushöhlung zu bilden.

2. Verfahren nach Anspruch 1, bei dem zwei der zu vergrabenden Flanken durch die zwei Ränder eines optischen Steges gebildet sind, der vergraben werden soll, und dass zwei sogenannte zu vergrabende Aushöhlungen durch zwei Kanäle beiderseits dieses Steges gebildet sind.

## Claims

1. Method of making an etched mark on a wafer such as a semiconductor wafer including a buried flank, the mark having the shape of an etched flank and defining the transverse position of at least one other etched flank formed in the wafer and constituting the buried flank, the mark and the buried flank being respectively formed within a mark area (1) and an area (7) to be buried and respectively comprising the edges of a mark recess and a recess to be buried etched in the areas,
which method comprises the following successive steps:
a) a protection layer (4) is deposited in the mark area and a register layer (5) is deposited on the protection layer, these two layers being of different composition,
b) a photosensitive resin (6) is deposited on the register layer and on the area to be buried,
c) the photosensitive resin is eliminated photolithographically in the areas of the mark recess and the recess to be buried to define future positions of the mark and the flank to be buried,
d) the wafer is etched to eliminate the part of the register layer that is not protected by the photosensitive resin, this etch sparing the resin (6), the protection layer (4) and the material of the wafer, the position of the mark being then defined by an edge of the register layer,
e) the wafer is etched to recess the flank to be buried, this etch sparing the photosensitive resin, the protection layer and the register layer,
f) the photosensitive resin is eliminated,
g) a burying material such as a semiconductor material is deposited, for example grown epitaxially, to bury the flank to be buried,
h) the material of the wafer is protected in the area to be buried, and
i) the wafer is etched to eliminate the part of the protection layer that is not protected by the register layer, this etch sparing the register layer and the protected material of the wafer and etching the material of the wafer that is not protected to form the mark recess.

2. Method according to claim 1 wherein the two flanks to be buried are constituted by two edges of an optical strip to be buried and the two recesses to be buried are constituted by two channels on either side of the strip.
